# EUROPEAN PATENT SPECIFICATION

(11) **EP 4 520 852 B1**
(45) Date of publication and mention of the grant of the patent: **15.04.2026**
(21) Application number: 24787044.7
(22) Date of filing: 01.07.2024
(51) Int. Cl.: H10K 71/00, H10K 71/60, H10K 77/10, C23C 14/14, C23C 14/02, C23C 14/04, C23C 14/24, C23C 14/20, G03F 7/00, H05K 3/00, H05K 3/10, H05K 3/14

(54) **THREE-DIMENSIONAL METAL ELECTRODE PATTERNING METHOD USING METAL DEPOSITION CONTROL MATERIAL**
VERFAHREN ZUR STRUKTURIERUNG EINER DREIDIMENSIONALEN METALLELEKTRODE MIT METALLABSCHEIDUNGSSTEUERUNGSMATERIAL
PROCÉDÉ DE FORMATION DE MOTIF D'ÉLECTRODE MÉTALLIQUE TRIDIMENSIONNELLE UTILISANT UN MATÉRIAU DE RÉGULATION DE DÉPÔT MÉTALLIQUE

(30) Priority: 07.07.2023 KR 20230088330
(43) Date of publication of application: 12.03.2025
(73) Proprietor: Seoul National University R&DB Foundation, Seoul 08826 (KR)
(72) Inventor: HONG, Yong Taek, Gwanak-gu Seoul 08826 (KR); YOON, Hyung Soo, Gwanak-gu Seoul 08826 (KR); JEONG, Su Jin, Gwanak-gu Seoul 08826 (KR)
(74) Representative: TRBL Intellectual Property
(86) International application number: PCT/KR2024/009176
(87) International publication number: WO 2025/014147

(56) References cited:
- EP-B1- 2 194 594
- KR-A- 20040 100 890
- KR-A- 20100 027 823
- KR-A- 20200 050 499
- KR-A- 20230 084 005
- KR-B1- 102 283 518
- US-A1- 2010 080 914

## Description

### [TECHNICAL FIELD]

The present invention relates to a 3-dimensional metal electrode patterning method using a metal deposition control material and a substrate having a 3-dimensional metal electrode pattern manufactured by the same, and more specifically, it relates to a method capable of patterning a 3-dimensional metal electrode without a conventionally commonly used rigid shadow or photo mask.

### [BACKGROUND ART]

A method of forming a conductive metal pattern using vacuum deposition is a technology widely used in various fields such as metal wiring for electrical and electronic circuits, OLED light emitting devices for displays and electrodes of semiconductor devices and the like. The most common method of forming a conductive metal pattern using vacuum deposition is a method of using a metal mask, which is, generally, a method of physically removing metals from the part where a pattern is to be formed by processing an alloy with a low thermal expansion coefficient, to prepare a metal mask, and through the part removed of this mask, selectively depositing an electrode.

Conventional electronic circuits and devices had morphological constraints that they should be made on a flat surface. However, as electronic circuits and devices can be recently implemented also on a 3-dimensional curved surface together with development of flexible and stretchable materials, attempts have been made to implement devices on substrates with various curvatures. A metal electrode patterning method using a metal pattern formation control material has previously been disclosed in KR 2023 0084005 A.

Metal, a material mainly used as an electrode, is a representative conductive material exhibiting high conductivity, and optical properties that can be adjusted from translucency to reflection. Even sufficiently thin metal thin film has mechanical durability in some degree, and therefore, it can be used also as a flexible electrode, but a problem that cracks are generated at a strain of about 2% to lead electrical defects is known. Thus, in case of the method of forming a metal electrode on a flat substrate first and deforming the substrate, there is a limitation in that it can only be applied within a curvature range that does not cause defects in the metal electrode. In particular, in case of a non-developable surface (for example, sphere, saddle, etc.) of which Gaussian curvature is not 0, a tensile strain is essential to completely cover an electrode sheet along the surface, so self-stretchability of the electrode is required, and as described above, the metal electrode is difficult to apply because they are vulnerable to tension.

In order to solve such problems, a method of forming a conductive pattern on the curved surface of a substrate directly, rather than a method of deforming an electrode according to a curved substrate, has been attempted. However, for patterning, a rigid shadow mask or photo mask or the like should be used, but such masks are difficult to apply to a curved substrate. As a method to exclude the use of a rigid mask, research of developing a flexible and deformable photo mask or shadow mask has also been reported, but since a subsequent process of removing the mask and leaving only a necessary metal thin film is required after a deposition process, there is a limit to increase in process complexity.

### [PRIOR ART]

### [PATENT DOCUMENT]

(Patent document 1) Korean Laid-open Publication No. 10-2018-0024969

### [DISCLOSURE]

### [TECHNICAL PROBLEM]

The present invention is to solve the afore-mentioned problems of the prior art, and an object is to provide a 3-dimensional metal electrode patterning method that can pattern a metal electrode pattern directly on a 3-dimensional curved substrate without a mask in a deposition process.

### [TECHNICAL SOLUTION]

In order to solve the afore-mentioned problems, the present invention provides a 3-dimensional metal electrode patterning method, comprising preparing a flat substrate; printing a metal deposition control material in an engraved pattern on the flat substrate; forming a 3-dimensional curved substrate by deforming the flat substrate by thermoforming or vacuum forming; and forming a metal electrode pattern by exposing the 3-dimensional curved substrate to metal vapor in a high-vacuum state without a mask, as the first embodiment of one example.

In addition, the present invention provides a 3-dimensional metal electrode patterning method, comprising preparing a carrier substrate; printing a metal deposition control material in an engraved pattern on the carrier substrate; preparing a 3-dimensonal curved substrate; transferring the engraved pattern on the carrier substrate to the 3-dimensional curved substrate by a transferring process; and forming a metal electrode pattern by exposing the 3-dimensional curved substrate to metal vapor in a high-vacuum state without a mask, as the second embodiment of one example.

According to one example, the metal deposition control material may comprise e-PVDF-HFP (Elastomeric poly(vinylidene fluoride-co-hexafluoropropylene)).

According to one example, the metal deposition control material may further comprise a solvent, and the solvent may comprise one selected from the group consisting of NMP (N-methyl-2-pyrrolidone), TEP (Triethyl phosphate), DMSO (Dimethyl sulfoxide), MIBK (Methyl isobutyl ketone), PGMEA (Propylene glycol methyl ether acetate) or a mixture thereof.

According to one example, the metal deposition control material may further comprise a crosslinking agent, and the crosslinking agent may comprise one selected from the group consisting of TAIC (1,3,5-Triallyl-1,3,5-triazinane-2,4,6-trione, BPO (dibenzoyl peroxide), DCP (Dicumylperoxide), PBP (Perbutyl peroxide), MIKP (Methyl isobutyl ketone peroxide), Dimethyl Di-t-butylperoxy hexane or a mixture thereof.

According to one example, the pressure in the high-vacuum state when the metal electrode pattern is formed may be 10⁻⁶ Torr.

According to one example, the metal electrode pattern may be formed by a metal or alloy comprising one selected from the group consisting of gold (Au), silver (Ag), magnesium (Mg), copper (Cu), iron (Fe), calcium (Ca) or a combination thereof.

According to one example, the forming a metal electrode pattern may be performed by Physical Vapor Deposition (PVD).

According to one example, the metal deposition control material may consist of a material exhibiting a tensile stress of less than 0.4 MPa in a tensile strain range of 0% to 800%.

According to one example, the flat substrate may have thermoplastic properties.

According to one example, the thermoforming may be performed in a temperature range of 100°C to 150°C.

According to one example, the carrier substrate may have surface energy of less than 25 mJ/m².

According to one example, the carrier substrate is a PDMS stamp (Polydimethylsiloxane Stamp).

A further embodiment, not forming part of the claimed invention, provides a substrate having a 3-dimensional metal electrode pattern, comprising a substrate having a 3-dimensional curved surface; a metal electrode pattern formed on at least a part of the 3-dimensional curved surface; a metal deposition control material region formed in a region other than a region in which the metal electrode pattern is formed on the 3-dimensional curved surface; wherein the metal electrode pattern is formed in a constant thickness, and the thickness of the metal deposition control material is formed thinner as the curvature of the 3-dimensional curved surface is larger, as another example.

According to another example, the metal deposition control material may comprise e-PVDF-HFP.

According to another example, the metal electrode pattern may be formed by a metal or alloy comprising one selected from the group consisting of gold (Au), silver (Ag), magnesium (Mg), copper (Cu), iron (Fe), calcium (Ca) or a combination thereof.

According to another example, the metal deposition control material may consist of a material exhibiting a tensile stress of less than 0.4 MPa in a tensile strain range of 0% to 800%.

### [ADVANTAGEOUS EFFECTS]

According to the composition of the present invention described above, a method capable of patterning a metal thin film electrode which has high electrical conductivity, has low surface roughness, and has a uniform thickness, on a 3-dimensional curved surface without defects, while consisting of a relatively simple process, can be provided.

### [BRIEF DESCRIPTION OF THE DRAWINGS]

FIG. 1 is a flowchart of the 3-dimensional metal electrode patterning method using a metal deposition control material according to the first embodiment of one example of the present invention.
FIG. 2 is a flowchart of the 3-dimensional metal electrode patterning method using a metal deposition control material according to the second embodiment of one example of the present invention.

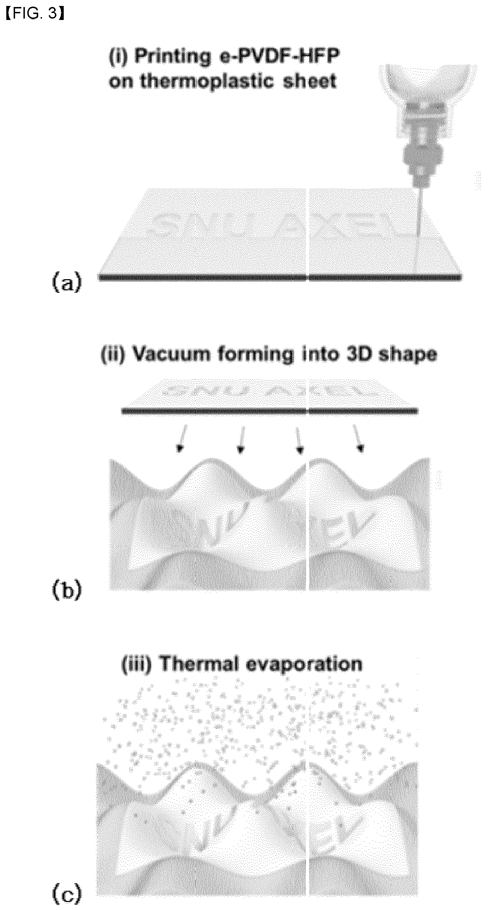

FIG. 3 briefly illustrates each step of the process of the first embodiment of the present invention in chronological order, and (a) shows the step of printing a metal deposition control material in an engraved pattern on a flat substrate, and (b) shows the step of forming a 3-dimensional curved substrate by vacuum forming, and (c) shows the step of forming a metal electrode pattern on the 3-dimensional curved substrate by vacuum deposition.
FIG. 4 are photographs illustrating the substrate having a 3-dimensional metal electrode pattern actually manufactured using the 3-dimensional metal electrode patterning method according to the present invention, and the left photograph is a photograph showing the 3-dimensional curved substrate formed by thermoforming, and the right photograph is a photograph showing a substrate forming a silver (Ag) electrode on this 3-dimensional curved substrate.
FIG. 5a shows the substrate having a 3-dimensional metal electrode pattern used in the experiment of the example of the present invention. The 3-dimensional curved shape of the illustrated substrate having a 3-dimensional metal electrode pattern was manufactured with amplitudes of 0 mm, 1 mm, 2 mm, and 5 mm, respectively, in order from the bottom.
FIG. 5b is a graph showing the result of the experiment of the example of the present invention, and shows the result values of resistance (Ω) and resistance per unit area (Ω·cm⁻²) according to each amplitude.

### [MODE FOR INVENTION]

Examples of the present disclosure are illustrated for the purpose of describing the technical spirit of the present disclosure. The scope according to the present disclosure are not limited to examples presented below or specific description of these examples.

All technical terms and scientific terms used in the present disclosure have meanings commonly understood by those skilled in the art to which the present disclosure belongs, unless otherwise defined. All terms used in the present disclosure are selected for the purpose of more clearly describing the present disclosure, and are not selected to limit the scope according to the present invention.

Expressions such as "comprising", "providing", "having" and the like used in the present disclosure, should be understood in open-ended terms encompassing the possibility of including other examples, unless otherwise stated in a phrase or sentence in which the corresponding expression is included.

In the present invention, when a part such as a layer, membrane, area, plate and the like is said to be "above" or "on" another part, this includes not only the case in that it is "directly on" another part, but also the case in that there is another part in between. On the contrary, when a part is said to be "right above" another part, it means that there is no other part in between. In addition, that it is said to be "above" or "on" the standard part means being positioned above or below of the standard part, and does not necessarily mean being positioned "above" or "on" the direction opposite to gravity.

In the present invention, "plane image" refers to the object of the present invention viewed from above, and "cross-sectional image" means the cross section, in which the object of the present invention is vertically cut, viewed from the side.

Expressions in a singular form described in the present disclosure may include a meaning of a plural form unless otherwise stated, and this is equally applied to expressions in a singular form described in claims.

Hereinafter, with reference to the accompanied drawings, the examples of the present invention will be described. In this process, the thickness of the lines or sizes of the elements, and the like illustrated in the drawings may be exaggeratedly illustrated for clarity and convenience of description. In addition, in the description of the following examples, describing the same or corresponding elements repeatedly may be omitted. However, even if description of the elements is omitted, it is not intended that such elements are not included in any example.

In addition, the following examples does not limit the scope of the present invention, but are only illustrative of elements presented in the claims of the present invention.

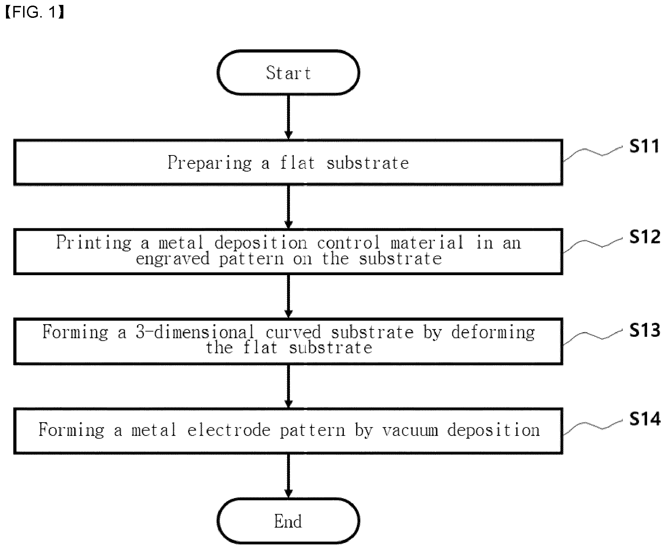

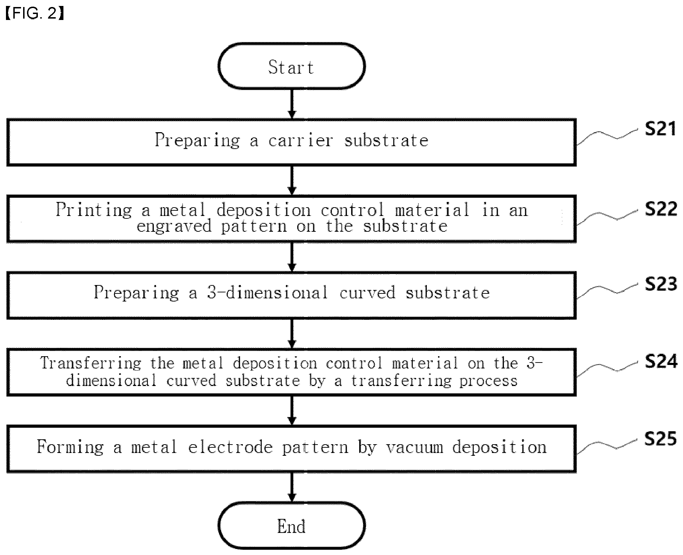

FIG. 1 is a drawing which shows a flowchart of the 3-dimensional metal electrode patterning method using a metal deposition control material according to the first embodiment of one example of the present invention, and FIG. 2 is a drawing which shows a flowchart of the 3-dimensional metal electrode patterning method using a metal deposition control material according to the second embodiment of one example of the present invention.

The 3-dimensional metal electrode patterning method according to the present invention starts from a conventionally known deposition technology which evaporates a metal source through heat or other energy supply, and deposits the evaporated metal particle in a gas state on the surface of a substrate to form a conductive metal pattern. This vacuum deposition is a method of coating a thin film by evaporating a metal source to be deposited into a gas state in a chamber in a high vacuum state, and is widely used for forming metal wiring for electrical and electronic circuits, or forming OLED light emitting devices for displays and electrodes of semiconductor devices. In particular, when a metal thin film is formed using vacuum deposition, not only can a pure metal thin film with excellent surface roughness and high conductivity be coated, but also can an extremely thin thickness at a level of several nm be formed, and thus, it can be used even for implementing electrodes with high transmittance.

The 3-dimensional metal electrode patterning method using a metal deposition control material according to one example of the present invention is that this conventional vacuum deposition technology is further improved, and it can form a 3-dimensional conductive metal pattern on a substrate without the use of a separate mask through a method of coating a material which can control growth of a metal deposition thin film, and at the same time, has intrinsically high stretchability.

### < First embodiment >

Hereinafter, at first, referring to FIG. 1, the 3-dimensional metal electrode patterning method using a metal deposition control material according to the first embodiment of one example of the present invention will be described in detail.

Referring to FIG. 1, the 3-dimensional metal electrode patterning method using a metal deposition control material according to the first embodiment of the present invention comprises preparing a flat substrate (S11); printing a metal deposition control material in an engraved pattern on the flat substrate (S12); forming a 3-dimensional curved substrate by deforming the flat substrate by thermoforming or vacuum forming (S13); and forming a metal electrode pattern by exposing the 3-dimensional curved substrate to metal vapor in a high-vacuum state without a mask (S14).

At first, a flat substrate is prepared (S11). It is preferable that the flat substrate used in the first embodiment of the present invention has thermoplastic properties so that it can be easily deformed through thermoforming or vacuum forming in a subsequent process. As one non-restrictive example, the material of the flat substrate may comprise polyethylene terephthalate (PET), polyethylene terephthalate Glycol (PETG) or poly carbonate (PC).

Next, a metal deposition control material is printed in an engraved pattern on the flat substrate (S12).

The metal deposition control material may comprise a polymer material which comprises a fluorine functional group and has low surface energy. As one non-restrictive example, the polymer material used as the metal deposition control material may comprise elastomeric Poly(vinylidene fluoride-co-hexafluoropropylene) (e-PVDF-HFP). The printing method of the metal deposition control material is not particularly limited, but it is preferable to apply it using a solution process, and for this, it may be manufactured in a transparent ink form.

The metal deposition control material should have intrinsically high stretchability, and specifically, it is preferably a material which can maintain a film form without breaking even in a tensile strain range of 1000%. In addition, the metal deposition control material preferably consists of a material exhibiting a tensile stress of less than 0.4 MPa in a tensile strain range of 0% to 800%.

To have physical properties (for example, viscosity, surface tension, boiling point, etc.) suitable for printing equipment, the metal deposition control material may comprise various solvents such as N-methyl-2-pyrrolidone (NMP), Triethyl phosphate (TEP), Dimethyl sulfoxide (DMSO), Methyl isobutyl ketone (MIBK), Propylene glycol methyl ether acetate (PGMEA), and the like.

In addition, the metal deposition control material may further comprise a crosslinking agent to secure mechanical flexibility of the printed pattern. The crosslinking agent may be one selected from the group consisting of TAIC (1,3,5-Triallyl-1,3,5-triazinane-2,4,6-trione, BPO (dibenzoyl peroxide), DCP (Dicumyl peroxide), PBP (Perbutyl peroxide), MIKP (Methyl isobutyl ketone peroxide), and dimethyl Di-t-butylperoxy hexane or a mixture thereof.

As one non-restrictive example, the composition ratio of the metal deposition control material may consist of e-PVDF-HFP of 1 to 50 wt%, a crosslinking agent of 0.05 to 3 wt%, and the remainder solvent.

The metal deposition control material is printed in an engraved pattern on a flat substrate, and then, the metal deposition control material is printed in the part in which a metal electrode pattern should not be formed on the flat substrate. The growth of a deposition thin film is affected by the surface energy of the substrate, and when the cohesion between metal atoms to be deposited is stronger than interaction with the lower substrate, it follows the Volmer-Weber mode in which the film grows in an island form. In addition, a phenomenon that some sources cannot cause a condensation reaction on the surface on which the metal deposition control material is applied and are desorbed occurs complexly, thereby controlling the growth rate of the deposition thin film.

The metal deposition control material may be applied using various printing equipment (for example, inkjet printer, pneumatic dispenser, EHD printer), and may be printed to form a certain pattern in an ink form using a printing process. As one non-restrictive example, the metal deposition control material may be applied using a roll-to-roll coating method.

The region in which the metal deposition control material is printed on a substrate does not form a metal thin film as the deposition rate is inhibited, so ink application is conducted by patterning the part other than the part in which the metal pattern is to be deposited in an engraved form. The thickness of the applied film is at a level inside and outside of several nm ~ 10 µm, and the applied ink may be used after heat treatment at a room temperature ~ 180°C, preferably, 100°C to 150°C. The line width of the pattern to be printed is limited by the ink application method of each process equipment, and for example, when an EHD printer is used, it is possible to implement a pattern with a minimum line width at a level of several tens of *µ*m, so even a fine pattern can be printed.

Then, a 3-dimensional curved substrate is formed by deforming the flat substrate by thermoforming or vacuum forming (S13).

Since the thermoforming or vacuum forming can be conducted using a conventionally known technology, in the present invention, a specific method for thermoforming or vacuum forming is not particularly limited. For example, a general vacuum forming method which sets a flat substrate on a frame in a vacuum chamber, and heats the flat substrate to make it flexible, and then produces vacuum to adhere the substrate to the frame to form it in a desired form may be used.

When the flat substrate is deformed by thermoforming or vacuum forming to deform it in a 3-dimensional curved form, the layer or film of the metal deposition control material printed thereon adapts to mechanical deformation, thereby being deformed along the 3-dimensional surface together. As described above, the metal deposition control material used in the present invention consists of a material which can maintain a film form without breaking even in a tensile strain range of 1000%, so despite of mechanical deformation into the 3-dimensional curved substrate, it can maintain the film form along the 3-dimensional surface. However, the degree of deformation is different in each part of the substrate, and the degree of the tensile strain also becomes different depending on the degree of deformation, and due to this, the layer thickness of the metal deposition control material region varies partially. For example, in the part where the curvature of the 3-dimensional curved surface is large, the metal deposition control material region may be greatly expanded, and thus, the total thickness of the metal deposition control material may be thin.

Finally, a metal electrode pattern is formed on the 3-dimensional curved substrate by exposing it to metal vapor in a high-vacuum state without a mask (S14).

Metal deposition is performed in a high vacuum, preferably, under a pressure of less than 10⁻⁶ Torr, by moving the 3-dimensional curved substrate, which has the metal deposition control material applied, and at the same time, is deformed through thermoforming or vacuum forming, to a vacuum deposition chamber. As one non-restrictive example, metal deposition may be performed by Physical Vapor Deposition (PVD). When deposition is performed on the substrate coated with the metal deposition control material, the metal is selectively deposited only in the region in which the metal deposition control material is not applied, even if a separate mask is not used, and patterning is possible without applying an additional wet process.

Metal sources used in the deposition process are not particularly limited, and any metal material capable of vacuum deposition may be used in the present invention. As one non-restrictive example, the metal electrode pattern may be formed with a metal or alloy comprising one selected from the group consisting of gold (Au), silver (Ag), magnesium (Mg), copper (Cu), iron (Fe), and calcium (Ca) or a combination thereof.

### < Second embodiment >

Next, referring to FIG. 2, the 3-dimensional metal electrode patterning method using a metal deposition control material according to the second embodiment of one example of the present invention will be described in detail. However, for concise description, description of the configuration overlapped with the first embodiment described above will be omitted.

Referring to FIG. 2, the 3-dimensional metal electrode patterning method using a metal deposition control material according to the second embodiment of one example of the present invention may comprise preparing a carrier substrate (S21); printing a metal deposition control material in an engraved pattern on the carrier substrate (S22); preparing a 3-dimensional curved substrate (S23); transferring the engraved pattern on the carrier substrate to the 3-dimensional curved substrate by a transferring process (S24); and forming a metal electrode pattern by exposing the 3-dimensional curved substrate to metal vapor in a high-vacuum state without a mask (S25).

At first, a carrier substrate is prepared (S21). It is preferable that the carrier substrate used in the second embodiment of the present invention has low surface energy so that the metal deposition control material can be easily transferred to the substrate with any curved surface in a subsequent transferring process. Further more specifically, the carrier substrate preferably has surface energy of less than 25 mJ/m². In addition, as one non-restrictive example, the carrier substrate is preferably a PDMS stamp (Polydimethylsiloxane stamp).

Next, the metal deposition control material is printed in an engraved pattern on the carrier substrate (S22). This step is substantially same as the printing a metal deposition control material in an engraved pattern on the flat substrate of the first embodiment studied above (S12), so the detailed description for this will be omitted.

After that, a 3-dimensional curved substrate is prepared (S23), and the engraved pattern on the carrier substrate is transferred on the 3-dimensional curved surface by a transferring process (S24). The method of forming the 3-dimensional curved substrate to be prepared in the second embodiment is not particularly limited. As one non-restrictive examples, similarly to the step S13 of the first embodiment studied above, the 3-dimensional curved substrate may be manufactured by deforming a flat substrate by thermoforming or vacuum forming.

In the transferring process, the carrier substrate, preferably, PDMS stamp is located on the surface of the prepared 3-dimensional curved substrate, and after that, by applying pressure, the metal deposition control material printed in an engraved pattern is transferred on the surface of the 3-dimensional curved substrate. Due to the flexibility of the carrier substrate, the carrier substrate is adhered to the surface of the 3-dimensional curved substrate, and as the carrier substrate has low surface energy, the metal deposition control material may be delivered from the carrier substrate to the surface of the 3-dimensional curved substrate.

Finally, by exposing the 3-dimensional curved substrate to metal vapor in a high-vacuum state without a mask, a metal electrode pattern is formed (S25). This step is substantially same as the step of forming a metal electrode pattern by exposing the 3-dimensional curved substrate in a high-vacuum state without a mask of the first embodiment studied above (S14), so the detailed description for this will be omitted.

### < Substrate having a 3-dimensional metal electrode pattern >

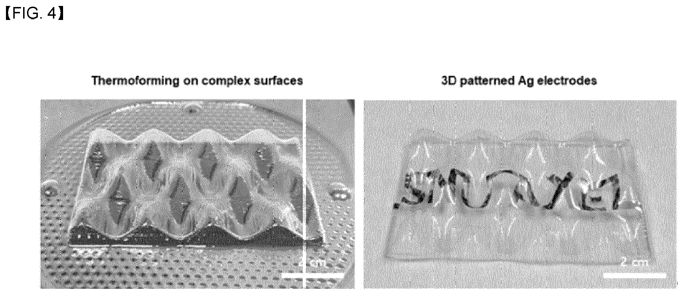

FIG. 4 is a drawing that illustrates the substrate manufactured using the 3-dimensional metal electrode patterning method according to the first embodiment of the present invention.

In case of the substrate having the 3-dimensional metal electrode pattern manufactured by the manufacturing method described above, in at least a part of the 3-dimensional curved surface of the substrate, a conductive metal electrode pattern is formed, and in at least other part of the 3-dimensional curved surface, for example, in the region other than the region where the metal electrode pattern is formed, a metal deposition control material region in which the metal deposition control material is applied is formed. As one non-restrictive example, the metal deposition control material region may be formed by printing and drying the metal deposition control material by a printing process. In addition, the conductive metal electrode pattern may be formed by a vacuum deposition process, preferably, PVD process.

According to the manufacturing method according to the first embodiment or the second embodiment of the present invention described above, the metal deposition control material is formed on the flat substrate or carrier substrate, and then, is deformed to have a 3-dimensional curved surface or is transferred on the 3-dimensional curved surface. The metal deposition control material used in the present invention has stretchability by itself, so it can be deformed along any 3-dimensional curved surface. Therefore, the metal deposition control material formed on the flat substrate is deformed together according to the form of the 3-dimensional curved substrate during thermoforming or vacuum forming of the flat substrate due to self-stretchability. Otherwise, in case of the second embodiment, the metal deposition control material formed on the carrier substrate is tension strained according to the form of the 3-dimensional curved substrate when transferred. At this time, the layer thickness of the metal deposition control material region varies partially depending on the deformed form of the substrate, and for example, the larger the curvature of the 3-dimensional curved surface, the more the metal deposition control material region increases, and therefore, the layer thickness becomes thinner.

As one non-restrictive example, the metal deposition control material is preferably e-PVDF-HFP. e-PVDF-HFP has advantages that it can maintain the film form without breaking even in a tensile strain range of 1000%, and it can easily deform it along any 3-dimensional curved surface even with little power, as it shows a tensile stress of less than 0.4 MPa in a tensile strain range of 0% to 800%.

In contrast to the layer of the metal deposition control material, the conductive metal electrode pattern is formed in a substantially constant thickness throughout the substrate, as deposition is achieved after it is deformed into a 3-dimensional curved substrate through thermoforming or vacuum forming. The conductive metal electrode pattern is not particularly limited, but it is preferably formed of a metal or alloy comprising one selected from the group consisting of gold (Au), silver (Ag), magnesium (Mg), cooper (Cu), iron (Fe), and calcium (Ca), or a combination thereof.

### < Example >

Hereinafter, the effect of the manufacturing method according to one example of the present invention will be described in detail through experimental results.

At first, by the manufacturing method according to the first embodiment described above, a substrate having a 3-dimensional metal electrode pattern was manufactured. Specifically, the present inventors prepared a polyethylene terephthalate Glycol (PETG) substrate as a substrate and applied a metal deposition control material, and then deformed this substrate into a 3-dimensional curved surface in a sine wave form by vacuum forming. After that, silver (Ag) was deposited in a shape with a width of 10 mm, and a length of 60 mm, under high vacuum of less than 10⁻⁶ torr by a PVD process to form a conductive metal electrode.

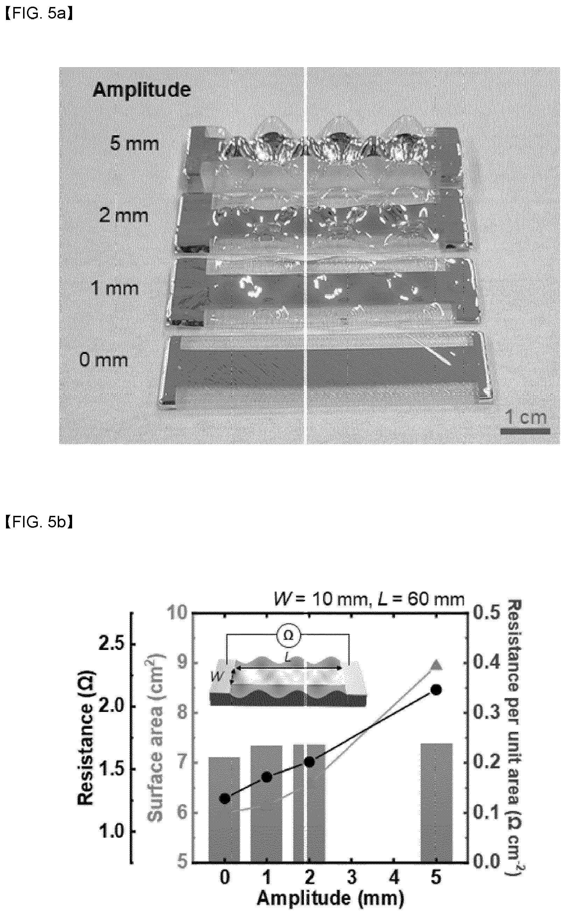

The present inventors formed a 3-dimensional curved surface by vacuum forming, and conducted the experiment while changing the amplitude to 0 mm, 1 mm, 2 mm, and 5 mm, respectively. FIG. 5a shows the actual results manufactured in this experiment. Afterwards, the resistance was measured on both sides of the conductive metal electrode pattern in the longitudinal direction for each substrate, and the results were shown in Table 1 and FIG. 5b.

**[Table 1]**

| **Classification** | **Amplitude (mm)** | **Maximum curvature (mm^{- 1})** | **Resistance (Ω)** | **Resistance per unit area (Ω·cm⁻²)** |
|---|---|---|---|---|
| Invention example 1 | 0 | 0 | 1.27 | 0.21 |
| Invention example 2 | 1 | 0.1 | 1.44 | 0.23 |
| Invention example 3 | 2 | 0.2 | 1.56 | 0.24 |
| Invention example 4 | 5 | 0.5 | 2.14 | 0.24 |

As a result of the experiment, it could be confirmed that the maximum curvature also became larger (0→0.5mm⁻¹), as the amplitude in a sine wave form increased (0→5mm), but when converted to resistance per unit area of the region where the electrode was formed, the resistance showed similar values at the level of 0.23 ± 0.01 Ω·cm⁻² under all amplitude conditions. Through this experiment, it could be confirmed that it is possible to deposit electrodes with uniform thickness on a 3-dimensional curved surface without influence of the curvature according to the manufacturing method according to one example of the present invention.

## Claims

1. A 3-dimensional metal electrode patterning method, comprising:
- preparing a flat substrate;
- printing a metal deposition control material in an engraved pattern on the flat substrate;
- forming a 3-dimensional curved substrate by deforming the flat substrate by thermoforming or vacuum forming; and
- forming a metal electrode pattern by exposing the 3-dimensional curved substrate to metal vapor in a high-vacuum state without a mask.

2. A 3-dimensional metal electrode patterning method, comprising:
- preparing a carrier substrate;
- printing a metal deposition control material in an engraved pattern on the carrier substrate;
- preparing a 3-dimensonal curved substrate;
- transferring the engraved pattern on the carrier substrate to the 3-dimensional curved substrate by a transferring process; and
- forming a metal electrode pattern by exposing the 3-dimensional curved substrate to metal vapor in a high-vacuum state without a mask.

3. The 3-dimensional metal electrode patterning method according to claim 1 or claim 2, wherein the metal deposition control material comprises elastomeric poly(vinylidene fluoride-co-hexafluoropropylene) (e-PVDF-HFP).

4. The 3-dimensional metal electrode patterning method according to claim 3, wherein the metal deposition control material further comprises a solvent, and the solvent comprises one selected from the group consisting of N-methyl-2-pyrrolidone (NMP), triethyl phosphate (TEP), dimethyl sulfoxide (DMSO), methyl isobutyl ketone (MIBK), propylene glycol methyl ether acetate (PGMEA) or a mixture thereof.

5. The 3-dimensional metal electrode patterning method according to claim 4, wherein the metal deposition control material further comprises a crosslinking agent, and the crosslinking agent comprises one selected from the group consisting of 1,3,5-triallyl-1,3,5-triazinane-2,4,6-trione (TAIC), dibenzoyl peroxide (BPO), dicumylperoxide (DCP), perbutyl peroxide (PBP), methyl isobutyl ketone peroxide (MIKP), dimethyl di-t-butylperoxy hexane or a mixture thereof.

6. The 3-dimensional metal electrode patterning method according to claim 1 or claim 2, wherein the pressure in the high-vacuum state is less than 10⁻⁶ Torr.

7. The 3-dimensional metal electrode patterning method according to claim 1 or claim 2, wherein the metal electrode pattern is formed by a metal or alloy comprising one selected from the group consisting of gold (Au), silver (Ag), magnesium (Mg), copper (Cu), iron (Fe), calcium (Ca) or a combination thereof.

8. The 3-dimensional metal electrode patterning method according to claim 1 or claim 2, wherein the forming a metal electrode pattern is performed by Physical Vapor Deposition (PVD).

9. The 3-dimensional metal electrode patterning method according to claim 1 or claim 2, wherein the metal deposition control material consists of a material exhibiting a tensile stress of less than 0.4 MPa in a tensile strain range of 0% to 800%.

10. The 3-dimensional metal electrode patterning method according to claim 1, wherein the flat substrate has thermoplastic properties.

11. The 3-dimensional metal electrode patterning method according to claim 1, wherein the thermoforming is performed in a temperature range of 100°C to 150°C.

12. The 3-dimensional metal electrode patterning method according to claim 2, wherein the carrier substrate has surface energy of less than 25 mJ/m².

13. The 3-dimensional metal electrode patterning method according to claim 2, wherein the carrier substrate is a polydimethylsiloxane stamp (PDMS stamp).

## Patentansprüche

1. Verfahren zur Strukturierung einer dreidimensionalen Metallelektrode, umfassend:
- Vorbereiten eines flachen Substrats;
- Drucken eines Metallabscheidungssteuerungsmaterials in einem eingravierten Muster auf das flache Substrat;
- Bilden eines dreidimensionalen gekrümmten Substrats durch Verformen des flachen Substrats durch Thermoformen oder Vakuumformen; und
- Bilden eines Metallelektrodenmusters durch Aussetzen des dreidimensionalen gekrümmten Substrats gegenüber Metalldampf in einem Hochvakuumzustand ohne eine Maske.

2. Verfahren zur Strukturierung einer dreidimensionalen Metallelektrode, umfassend:
- Vorbereiten eines Trägersubstrats;
- Drucken eines Metallabscheidungssteuerungsmaterials in einem eingravierten Muster auf das Trägersubstrat;
- Herstellen eines dreidimensionalen gekrümmten Substrats;
- Übertragen des eingravierten Musters auf dem Trägersubstrat auf das dreidimensionale gekrümmte Substrat durch einen Übertragungsprozess; und
- Bilden eines Metallelektrodenmusters durch Aussetzen des dreidimensionalen gekrümmten Substrats gegenüber Metalldampf in einem Hochvakuumzustand ohne eine Maske.

3. Verfahren zur Strukturierung einer dreidimensionalen Metallelektrode nach Anspruch 1 oder Anspruch 2, wobei das Metallabscheidungssteuerungsmaterial elastomeres Poly(vinylidenfluorid-co-hexafluoropropylen) (e-PVDF-HFP) umfasst.

4. Verfahren zur Strukturierung einer dreidimensionalen Metallelektrode nach Anspruch 3, wobei das Metallabscheidungssteuerungsmaterial ferner ein Lösungsmittel umfasst und das Lösungsmittel eines ausgewählt aus der Gruppe bestehend aus N-Methyl-2-pyrrolidon (NMP), Triethylphosphat (TEP), Dimethylsulfoxid (DMSO), Methylisobutylketon (MIBK), Propylenglykolmethyletheracetat (PGMEA) oder ein Gemisch davon umfasst.

5. Verfahren zur Strukturierung einer dreidimensionalen Metallelektrode nach Anspruch 4, wobei das Metallabscheidungssteuerungsmaterial ferner ein Vernetzungsmittel umfasst, und das Vernetzungsmittel eines ausgewählt aus der Gruppe bestehend aus 1,3,5-Triallyl-1,3,5-Triazinan-2,4,6-Trion (TAIC), Dibenzoylperoxid (BPO), Dicumylperoxid (DCP), Perbutylperoxid (PBP), Methylisobutylketonperoxid (MIKP), Dimethyl-di-t-butylperoxyhexan oder einem Gemisch davon umfasst.

6. Verfahren zur Strukturierung einer dreidimensionalen Metallelektrode nach Anspruch 1 oder Anspruch 2, wobei der Druck im Hochvakuumzustand weniger als 10⁻⁶ Torr beträgt.

7. Verfahren zur Strukturierung einer dreidimensionalen Metallelektrode nach Anspruch 1 oder Anspruch 2, wobei das Metallelektrodenmuster durch ein Metall oder eine Legierung gebildet wird, umfassend eines ausgewählt aus der Gruppe bestehend aus Gold (Au), Silber (Ag), Magnesium (Mg), Kupfer (Cu), Eisen (Fe), Calcium (Ca) oder einer Kombination davon.

8. Verfahren zur Strukturierung einer dreidimensionalen Metallelektrode nach Anspruch 1 oder Anspruch 2, wobei das Bilden eines Metallelektrodenmusters durch Physikalische Gasphasenabscheidung (PVD) durchgeführt wird.

9. Verfahren zur Strukturierung einer dreidimensionalen Metallelektrode nach Anspruch 1 oder Anspruch 2, wobei das Metallabscheidungssteuerungsmaterial aus einem Material besteht, das eine Zugspannung von weniger als 0,4 MPa in einem Zugspannungsbereich von 0 % bis 800 % aufzeigt.

10. Verfahren zur Strukturierung einer dreidimensionalen Metallelektrode nach Anspruch 1, wobei das flache Substrat thermoplastische Eigenschaften aufweist.

11. Verfahren zur Strukturierung einer dreidimensionalen Metallelektrode nach Anspruch 1, wobei das Thermoformen in einem Temperaturbereich von 100 °C bis 150 °C durchgeführt wird.

12. Verfahren zur Strukturierung einer dreidimensionalen Metallelektrode nach Anspruch 2, wobei das Trägersubstrat eine Oberflächenenergie von weniger als 25 mJ/m² aufweist.

13. Verfahren zur Strukturierung einer dreidimensionalen Metallelektrode nach Anspruch 2, wobei das Trägersubstrat ein Polydimethylsiloxan-Stempel (PDMS-Stempel) ist.

## Revendications

1. Procédé de formation d'un motif d'électrode métallique tridimensionnelle, comprenant :
- préparer un substrat plat ;
- imprimer un matériau de contrôle du dépôt métallique selon un motif gravé sur ledit substrat plat ;
- former un substrat courbe tridimensionnel en déformant ledit substrat plat par thermoformage ou formage sous vide ; et
- former un motif d'électrode métallique en exposant ledit substrat courbe tridimensionnel à une vapeur métallique dans un état de vide poussé sans masque.

2. Procédé de formation d'un motif d'électrode métallique tridimensionnelle, comprenant :
- préparer un substrat support ;
- imprimer un matériau de contrôle du dépôt métallique selon un motif gravé sur ledit substrat support ;
- préparer un substrat courbe tridimensionnel ;
- transférer ledit motif gravé sur ledit substrat support vers ledit substrat courbe tridimensionnel par un procédé de transfert ; et
- former un motif d'électrode métallique en exposant ledit substrat courbe tridimensionnel à une vapeur métallique dans un état de vide poussé sans masque.

3. Procédé de formation d'un motif d'électrode métallique tridimensionnelle selon la revendication 1 ou la revendication 2, dans lequel ledit matériau de contrôle du dépôt métallique comprend poly(fluorure de vinylidène-co-hexafluoropropylène) élastomère (e-PVDF-HFP).

4. Procédé de formation d'un motif d'électrode métallique tridimensionnelle selon la revendication 3, dans lequel ledit matériau de contrôle du dépôt métallique comprend en outre un solvant, et ledit solvant comprend un solvant sélectionné dans le groupe constitué de N-méthyl-2-pyrrolidone (NMP), phosphate de triéthyle (TEP), diméthylsulfoxyde (DMSO), méthylisobutylcétone (MIBK), acétate de méthyléther de propylène glycol (PGMEA) ou un mélange de ceux-ci.

5. Procédé de formation d'un motif d'électrode métallique tridimensionnelle selon la revendication 4, dans lequel ledit matériau de contrôle du dépôt métallique comprend en outre un agent de réticulation, et ledit agent de réticulation comprend un agent sélectionné dans le groupe constitué de 1,3,5-triallyl-1,3,5-triazinane-2,4,6-trione (TAIC), peroxyde de dibenzoyle (BPO), peroxyde de dicumyle (DCP), peroxyde de perbutyle (PBP), peroxyde de méthylisobutylcétone (MIKP), diméthyl di-t-butylperoxy hexane ou un mélange de ceux-ci.

6. Procédé de formation d'un motif d'électrode métallique tridimensionnelle selon la revendication 1 ou la revendication 2, dans lequel la pression dans ledit état de vide poussé est inférieure à 10⁻⁶ Torr.

7. Procédé de formation d'un motif d'électrode métallique tridimensionnelle selon la revendication 1 ou la revendication 2, dans lequel ledit motif d'électrode métallique est formé par un métal ou un alliage comprenant un métal sélectionné dans le groupe constitué d'or (Au), d'argent (Ag), de magnésium (Mg), de cuivre (Cu), de fer (Fe), de calcium (Ca) ou une combinaison de ceux-ci.

8. Procédé de formation d'un motif d'électrode métallique tridimensionnelle selon la revendication 1 ou la revendication 2, dans lequel la formation dudit motif d'électrode métallique est réalisée par dépôt physique en phase vapeur (PVD).

9. Procédé de formation d'un motif d'électrode métallique tridimensionnelle selon la revendication 1 ou la revendication 2, dans lequel ledit matériau de contrôle du dépôt métallique est constitué d'un matériau présentant une contrainte de traction inférieure à 0,4 MPa dans une plage de déformation en traction de 0 % à 800 %.

10. Procédé de formation d'un motif d'électrode métallique tridimensionnelle selon la revendication 1, dans lequel ledit substrat plat présente des propriétés thermoplastiques.

11. Procédé de formation d'un motif d'électrode métallique tridimensionnelle selon la revendication 1, dans lequel ledit thermoformage est réalisé dans une plage de température de 100 °C à 150 °C.

12. Procédé de formation d'un motif d'électrode métallique tridimensionnelle selon la revendication 2, dans lequel ledit substrat support présente une énergie de surface inférieure à 25 mJ/m².

13. Procédé de formation d'un motif d'électrode métallique tridimensionnelle selon la revendication 2, dans lequel ledit substrat support est un tampon en polydiméthylsiloxane (tampon PDMS).
